# EUROPEAN PATENT APPLICATION

(11) **EP 4 456 343 A1**
(43) Date of publication of application: **30.10.2024**
(21) Application number: 23812211.3
(22) Date of filing: 26.05.2023
(51) Int. Cl.: H01S 5/024, H04B 10/50, H01S 5/12, H01S 5/0625, H01S 5/183, G02B 6/12, H01S 5/32

(54) **OPTICAL DEVICE**

(30) Priority: 26.05.2022 KR 20220064893; 26.05.2022 KR 20220064894; 26.05.2022 KR 20220064895
(71) Applicant: PHOVEL.CO., LTD, 34302 Daejeon (KR)
(72) Inventor: KIM, Jeong Soo, Janggun-myeon, Sejong 30056 (KR)
(74) Representative: von Bülow & Tamada
(86) International application number: PCT/KR2023/007309
(87) International publication number: WO 2023/229437

(57) **Abstract**

The present invention provides an optical device comprising: a first cladding layer formed on a substrate; a multiple quantum well (MQW) active layer formed on the first cladding layer all over a light source area and a modulator area; a second cladding layer formed on the MQW active layer; and a heater, which applies heat to the MQW active layer corresponding to the light source area, and thus controls an energy bandgap of a light source.

## Description

### [Technical Field]

The present invention relates to an optical device in which a modulator and a light source of a distributed feedback laser diode (DFB-LD) or distributed bragg reflector (DBR-LD) structure having the same active layer are integrated with each other.

### [Background Art]

Current optical communication may use a laser light source of a direct laser modulation structure such as a distributed feedback laser diode (DFB-LD) or a distributed bragg reflector (DBR-LD), or use an external modulation method of integrating the DFB-LD or the DBR-LD and an electro-absorption (EA) modulator or a mach zehnder (MZ) modulator with each other.

An electro modulated laser (EML), in which the light source such as light source (example, the DFB-LD and so on) and the electro-absorption (EA) modulator or the mach zehnder (MZ) modulator are integrated with each other, may enable high-speed and long-distance communication by minimizing a chirp phenomenon that occurs when performing the direct current modulation on the light source such as the DFB-LD.

In particular, in the case of an EML light source having the integrated EA modulator, it is preferable that a bandgap wavelength of a semiconductor material in a DFB-LD area and a bandgap wavelength of a semiconductor material in an EA modulator area have different features. Typically, it is preferable that the bandgap wavelength of an optical gain area such as the DFB-LD has a wavelength longer by about 20 nm to 40 nm than the bandgap wavelength of the EA modulator area. In epi-crystal growth for producing the laser light source, a method of varying the bandgap wavelength of the DFB-LD area and that of the EA modulator area from each other has been applied in a very limited, such as a selective area growth (SAG) technique. Typically, a unit price of an optical device is high because an epi-crystal manufacturing method is very difficult, such as growing the crystal in the DFB-LD area, then removing the epi-crystal for the DFB-LD from an area where the modulator is to fit, and growing an epi-crystal appropriate for the modulator again.

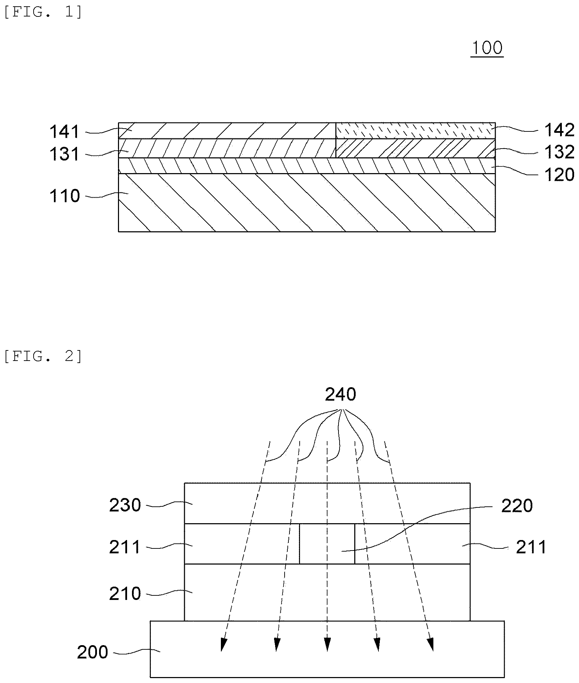

FIG. 1 is a diagram for explaining a prior modulator integrated light source (EML).

Referring to FIG. 1, a modulator integrated light source (EML) 100 may include a substrate 110, a first cladding layer 120, a first MQW active layer 131, a second MQW active layer 132, a second cladding layer 141, and a third cladding layer 142. Here, MQW stands for a multiple quantum well.

The first cladding layer 120 may be formed on the substrate 110.

The first MQW active layer 131 may be formed on one side (left side in FIG. 1) of the first cladding layer 120.

The second MQW active layer 132 may be formed on the other side (right side in FIG. 1) of the first cladding layer 120. Here, the first MQW active layer 131 and the second MQW active layer 132 may be disposed on the same plane, and may be formed on the first cladding layer 120 in various ways.

An area of the first MQW active layer 131 may correspond to the light source, and an area of the second MQW active layer 132 may correspond to the modulator.

An energy bandgap of the second MQW active layer 132 may be larger than an energy bandgap of the first MQW active layer 131.

The second cladding layer 141 may be formed on the first MQW active layer 131.

The third cladding layer 142 may be formed on the second MQW active layer 132.

As described above, the prior modulator integrated light source (EML) may include the first MQW active layer 131 and the second MQW active layer 132 having different energy bandgaps in order to ensure that the energy bandgap of the light source area has a smaller value than the energy bandgap of the modulator area.

In order to have the first MQW active layer 131 and the second MQW active layer 132 having the different energy bandgaps, the first MQW active layer 131 may be first grown, the first MQW active layer 131 may be etched from an area where the modulator is to be grown, and the second MQW active layer 132 of the modulator may be grown in the etched area. In this process, controlling an etching depth, stabilizing an etched surface, and re-growing an epi-crystal may be very difficult processes, thus causing various problems during this process.

FIG. 2 is a diagram for explaining a path through which heat generated in a heater having a prior structure is transmitted.

Referring to FIG. 2, a first cladding layer 210 may be formed on a substrate 200.

Two second cladding layers 211 may be formed on the first cladding layer 210.

A MWQ active layer 220 may be formed in a middle portion of the second cladding layer 211. As shown in FIG. 2, the MWQ active layer 220 may have a very narrow width (for example, about 1.5 um to 2 um).

In this prior art, heat generated by the heater (not shown) may not be transmitted by being concentrated on the MWQ active layer 220, but transmitted to an entire surrounding area 240. Therefore, the heat generated by the heater may not entirely contribute to an increase in a temperature of the MWQ active layer 220, and transmitted inefficiently, resulting in a significant decrease in overall energy efficiency.

In addition, a spatial resolution of a semiconductor lithography method used to manufacture an optical device may be about 1 um. Therefore, it may be very difficult to manufacture the heater on the MWQ active layer 220 having the narrow width of about 1.5 um to 2 um.

Currently, an internationally-standardized communication method such as NG-PON2 (IEEE G.989.2) may use the light source by a time domain multiplexing (TDM) method, and a plurality of subscribers may use one optical wavelength channel by dividing the same in time. That is, a subscriber not using the communication may be required to completely turn off a laser light source. Therefore, in the time domain multiplexing (TDM) method, the light source may alternate between being completely off and on (on-off). An oscillation wavelength of a semiconductor laser may be changed sensitively based on a temperature. Therefore, the light source of an EML device, in which a light source of a DFB-LD device and a modulator are coupled to each other, may also be required to be turned on and off (or to be in a "burst mode"). In the time domain multiplexing (TDM) method, when the light source is turned on, the temperature of the light source may be changed due to self-heat generated in the light source, thus changing a wavelength of the light source.

The above information disclosed in this Background section is provided only to assist in better understanding of the background of the present invention, and may thus include information not included in the prior art already known to those skilled in the art to which the present invention pertains.

### [National research and development project supporting the present invention]

[Project original number] 2022000523
[Project number] 2022-0-00523
[Ministry Name] Ministry of Science and ICT
[Project management (professional) organization name] Information and Communications Planning and Evaluation Institute
[Research field name] Broadcasting and communication industry technology development
[Research project name] Development of 25Gbps-based 4-channel 100Gbps NG-PON2+ transceiver
[Contribution rate] 1/1
[Name of project carrying out organization] Fovell Co., Ltd.
[Research period] April 1, 2022 to December 31, 2024

### [Disclosure]

### [Technical Problem]

An object of the present invention is to provide an optical device in which an energy bandgap of a light source area is reduced using a heater in a situation where the light source area and a modulator area have the same the energy bandgap to thus enable the light source area to have a smaller energy bandgap than the modulator area, thus normally operating the modulator.

Another object of the present invention is to provide an optical device which may be very easily manufactured by including a second cladding layer having a width wider toward its upper side to thus enable an electrode or the like to be conveniently formed on the wider upper side.

Still another object of the present invention is to provide an optical device in which a second cladding layer has a width wider toward its upper side to thus allow heat generated in a heater to be concentrated in an active area rather than dispersed, thereby not only allowing desired heat to be transmitted to the active area in a short period of time, but also having excellent thermal energy efficiency as heat is not dispersed.

Yet another object of the present invention is to provide an optical device in which when a light source is turned on in a burst mode, thermal power of a heater is controlled to offset thermal power generated when the light source is turned on to thus maintain constant total thermal power throughout entire time, thereby allowing not only a wavelength of the light source to remain constant, but also an energy bandgap to remain constant even when time is changed.

### [Technical Solution]

According to an embodiment of the present invention, an optical device includes: a first cladding layer formed on a substrate; a multiple quantum well (MQW) active layer formed on the first cladding layer all over a light source area and a modulator area; a second cladding layer formed on the MQW active layer; and a heater controlling an energy bandgap of a light source by applying heat to the MQW active layer corresponding to the light source area.

The heater may increase a temperature of the MQW active layer corresponding to the light source area by applying heat thereto to thus reduce the light source energy bandgap, thereby making the light source energy bandgap smaller than a modulator energy bandgap in the modulator area.

The second cladding layer in the light source area may have a lower width that is smaller than an upper width.

The device may further include: a first electrode formed on the second cladding layer; and an insulating film formed on the first electrode, wherein the heater is formed on the insulating film.

For the second cladding layer, a height of the cladding layer formed in the light source area or in the modulator area may be higher than a height of the cladding layer formed between the light source area and the modulator area.

The device may further include a second electrode formed on the second cladding layer in the modulator area.

The heater may maintain thermal power P to form a desired light source energy bandgap of the light source area, and in a case where the optical device is driven in a burst mode, the thermal power P of the heater may be changed to the thermal power P minus thermal power R (P-R) when the light source is turned on and the thermal power R is generated in the burst mode, thus allowing the thermal power P to remain constant even though the optical device is driven in the burst mode.

### [Advantageous Effects]

The present invention may provide the optical device in which the energy bandgap of the light source area is reduced using the heater in the situation where the light source area and the modulator area have the same the energy bandgap to thus enable the light source area to have the smaller energy bandgap than the modulator area, thus normally operating the modulator.

The present invention may also provide the optical device which may be very easily manufactured by including the second cladding layer having the width wider toward its upper side to thus enable the electrode or the like to be conveniently formed on the wider upper side.

The present invention may also provide the optical device in which the second cladding layer has the width wider toward its upper side to thus allow heat generated by the heater to be concentrated in the active area rather than dispersed, thereby not only allowing desired heat to be transmitted to the active area in the short period of time, but also having the excellent thermal energy efficiency as heat is not dispersed.

The present invention may also provide the optical device in which when the light source is turned on in the burst mode, the thermal power of the heater is controlled to offset the thermal power generated when the light source is turned on to thus maintain the constant total thermal power throughout the entire time, thereby allowing not only the wavelength of the light source to remain constant, but also the energy bandgap to remain constant even when the time is changed.

### [Description of Drawings]

FIG. 1 is a diagram for explaining a prior modulator integrated light source (EML).
FIG. 2 is a diagram for explaining a direction in which heat generated in a prior heater is radiated.
FIGS. 3 and 4 are diagrams for explaining principles of light emission and light absorption.
FIGS. 5 and 6 are diagrams for explaining a principle of light modulation in an optical device in which a light source and modulator are integrated with each other.
FIGS. 7, 8, 9, and 10 are diagrams for explaining an optical device according to an embodiment of the present invention.
FIG. 11 is a diagram for explaining a method of adjusting an energy bandgap in the optical device according to an embodiment of the present invention.
FIG. 12 is a diagram for explaining a method of controlling a heater when the optical device is operated in a burst mode according to an embodiment of the present invention.

### [DETAILED DESCRIPTION]

Hereinafter, detailed contents for embodying the present invention will be described in detail with reference to the accompanying drawings.

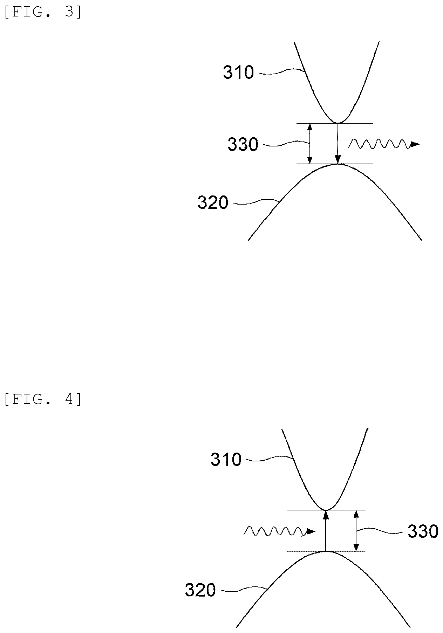

FIGS. 3 and 4 are diagrams for explaining principles of light emission and light absorption.

Referring to FIG. 3, when a current is injected in a p-n junction structure, electrons may be moved, exceeding an energy band gap 330 between a conduction band 310 and a valence band 320 shown by a semiconductor epi-crystal structure, and a photon of a wavelength corresponding to this energy may be emitted.

Referring to FIG. 4, when light is absorbed in a semiconductor, photon energy exceeding the energy bandgap of 330 may be absorbed, and electrons may be moved from the valence band 320 to the conduction band 310, thus causing the light absorption.

Therefore, when the light source and the modulator have the same energy gap, light emitted from the light source may be easily absorbed by the modulator, thus reducing transmittance of the modulator.

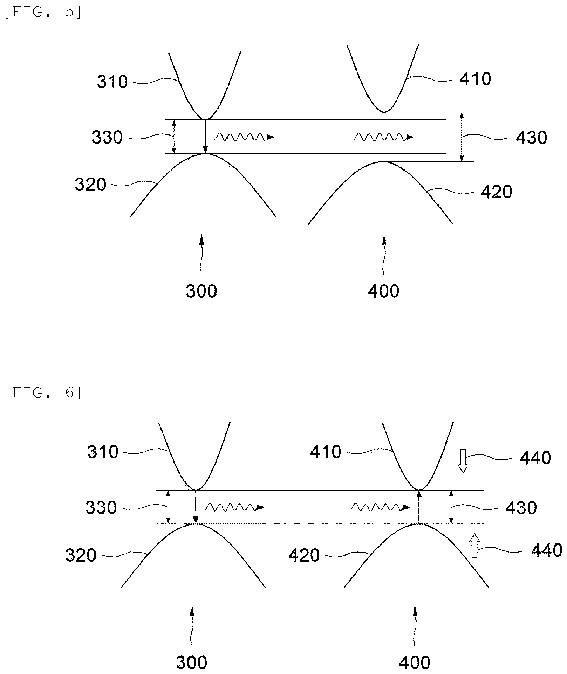

FIGS. 5 and 6 are diagrams for explaining a principle of light modulation in an optical device in which the light source and modulator are integrated with each other.

Referring to FIGS. 5 and 6, the description describes light modulation based on a case where an energy bandgap 430 of the modulator area is larger than the energy bandgap 330 of the light source area.

Referring to FIG. 5, the light source and the modulator may be divided into a light source area 300 and a modulator area 400.

In the light source area 300, the electrons may be moved, exceeding the energy band gap 330 between the conduction band 310 and the valence band 320, and the photon of the wavelength corresponding to this energy may be emitted.

In the modulator area 400, a reverse voltage may not be applied to the modulator. Therefore, the energy bandgap 430 of the modulator area 400 may be larger than the energy bandgap of the light source area 300 when a size of the energy band gap 430 of the modulator between the conduction band 410 and the valence band 420 is not changed. Accordingly, light of the energy emitted from the light source may not be absorbed by the modulator and pass through the modulator as it is.

Referring to FIG. 6, when the reverse voltage is applied to the modulator, the energy bandgap 430 of the modulator may be reduced to be an energy bandgap 440 by a quantum confined stark effect (QCSE) (for example, the energy bandgap may be equal to the energy band gap 330 of the light source). In this case, the modulator area may effectively absorb light emitted from the light source, thus showing a basic feature (function) of the modulator. As described above, it may be seen that the modulator is operated smoothly when the energy bandgap of the modulator area is larger than the energy bandgap of the light source area.

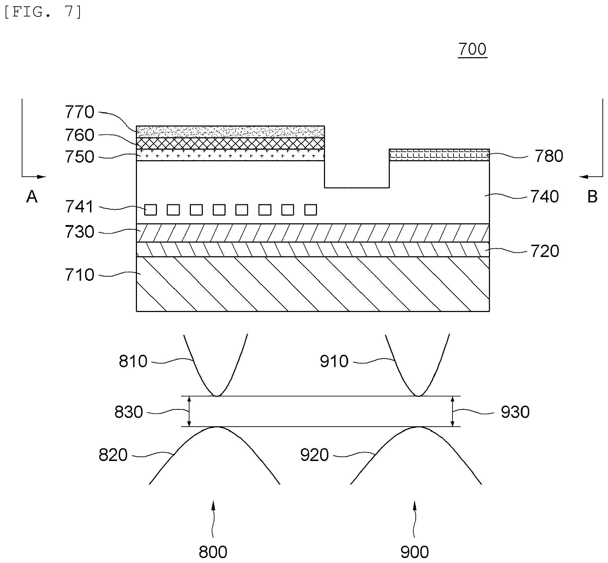

FIGS. 7, 8, 9, and 10 are diagrams for explaining an optical device according to an embodiment of the present invention.

Referring to FIG. 7, an optical device 700 may include a substrate 710, a first cladding layer 720, a multiple quantum well (MQW) active layer 730, a second cladding layer 740, a first electrode 750, an insulating film 760, a heater 770, a second electrode 780, and a controller (not shown).

A light source included in the optical device 700 may have a DFB-LD or DBR-LD structure.

The first cladding layer 720 may be formed on the substrate 710.

The MQW active layer 730 may be formed on the first cladding layer 720. The MQW active layer 131 may be formed by one-time epi-crystal growth over both of a light source area 800, which is a left area in FIG. 7, and a modulator area 900, which is a right area in FIG. 7, and the same MQW active layer, rather than different MQW active layers, may thus be formed on the first cladding layer 720.

The second cladding layer 740 may be formed on the MQW active layer 730. For the second cladding layer 740, the cladding layers formed in the light source area 800 and the modulator area 900 may have almost the same height, and the cladding layer formed between the light source area 800 and the modulator area 900 may be lower than the height of the cladding layer formed in the light source area 800 or the modulator area 900.

The second cladding layer 740 may further include a grating part 740 on its inner lower side.

In another embodiment, the grating part 740 may be formed on the first cladding layer 720 rather than the second cladding layer 740.

The first electrode 750 may be formed on the second cladding layer 740 of the light source area 800.

The first electrode 750 may be a P electrode, and the electrons on the electrode may be moved to the MQW active layer 730 through the second cladding layer 740.

The insulating film 760 may be formed between the first electrode 750 and the heater 770. The insulating film 760 may insulate the first electrode 750 and the heater 770 from each other.

The heater 770 may generate heat, and generated heat may be transmitted to the MQW active layer 730 through the first electrode 750, the second cladding layer 740, and the like.

The second electrode 780 may be formed on the second cladding layer 740 of the modulator area 900.

The second electrode 780 may be an electrode used to apply the reverse voltage to the modulator. When the reverse voltage is applied to the modulator by using the second electrode 780, an energy bandgap 930 of the modulator may be reduced by the quantum confined stark effect (QCSE).

The MQW active layer 730 may be formed equally across the light source area 800 and the modulator area 900. Therefore, a light source energy bandgap 830 between the conduction band 810 and valence band 820 of the light source area 800 and the modulator energy bandgap 930 between the conduction band 910 and valence band 920 of the modulator area 900 may be the same as each other.

The controller (not shown) may control operations of the components disposed in the optical device. For example, the controller (not shown) may control the first electrode, the second electrode, heater, or the like based on an input control signal.

A connection area between the light source and a modulator conversion part may be an electrical isolation area.

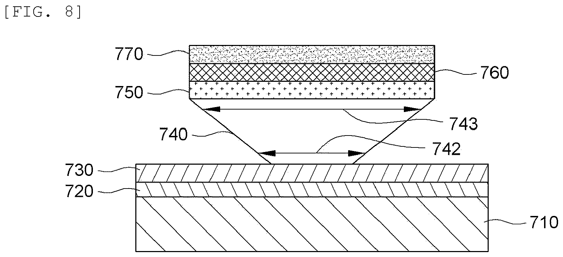

FIG. 8 is a diagram of the second cladding layer 740, the first electrode 750, the insulating film 760, and the heater 770, viewed in direction A shown in FIG. 7.

Referring to FIG. 8, the second cladding layer 740 may have a lower width 742 that is smaller than an upper width 743. For example, the second cladding layer 740 may have a reverse mesa structure.

The second cladding layer 740 may have the same structure as shown in FIG. 8. Therefore, the first electrode 750, the insulating film 760, and the heater 770 may not be formed in a narrow area such as the lower width 742 of the second cladding layer 740, and may be installed in a wide area such as the upper width 743 of the second cladding layer 740. As a result, the optical device may be very easily manufactured.

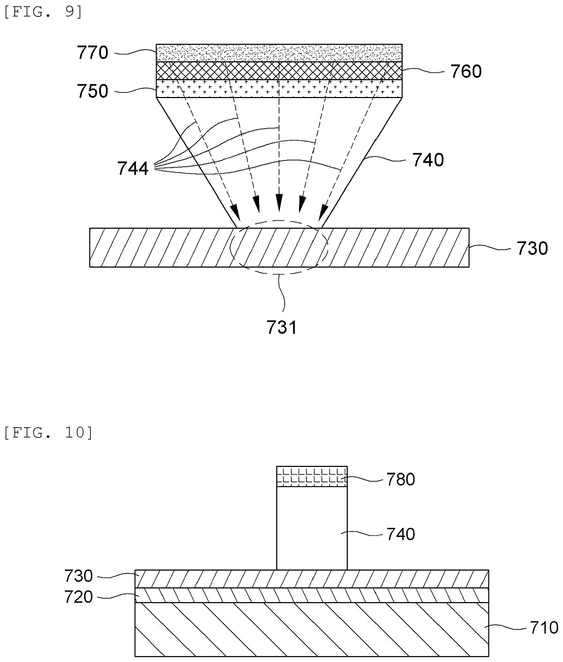

FIG. 9 is a diagram for explaining a path through which heat generated by the heater in FIG. 8 is moved.

Referring to FIG. 9, heat generated by the heater 770 may achieve its movement 744 without dispersion while being concentrated in an active area 731 of the MQW active layer 730 along a structure of the second cladding layer 740.

According to this embodiment, the optical device may have a structure in which heat generated by the heater 770 is concentrated in the active area 731 rather than being dispersed, thereby not only transmitting desired heat to the active area 731 in a short period of time, but also securing very excellent thermal energy efficiency as heat is not dispersed.

FIG. 10 is a diagram of the second cladding layer 740 and the second electrode 780, viewed in direction B shown in FIG. 7.

Referring to FIG. 10, the second cladding layer 740 in the modulator area may be perpendicular to the MQW active layer 730. For example, the second cladding layer 740 may have a vertical mesa structure, is not limited to this structure, and may have various structures.

The second cladding layer 780 may be formed on the second cladding layer 740.

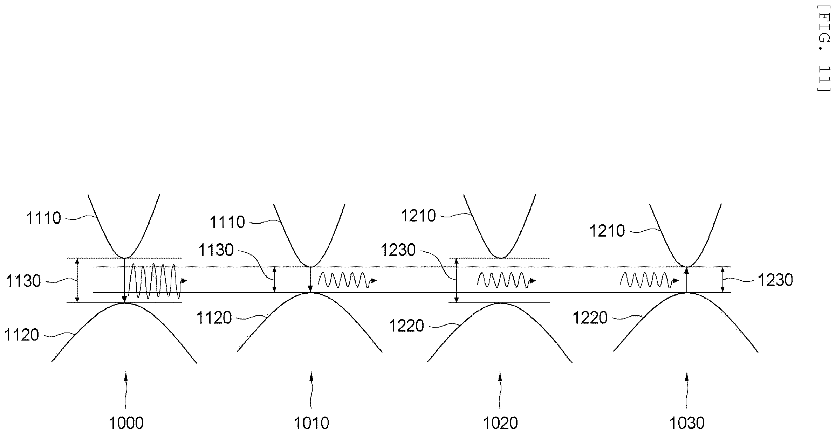

FIG. 11 is a diagram for explaining a method of adjusting the energy bandgap in the optical device according to an embodiment of the present invention.

Referring to FIG. 11, as described in FIG. 7, a light source energy bandgap 1130 of a light source area 1000 and a modulation energy bandgap 1230 of a modulator area 1020 may have the same value.

However, in order to demonstrate normal modulator feature (performance), the light source energy bandgap 1130 may be required to be smaller than the modulation energy bandgap 1230 of the modulator area 1020.

Accordingly, in the present invention, the light source energy bandgap 1130 may be reduced by increasing a temperature of the light source area 1000 by applying heat thereto by using the heater.

For example, the reduction of the energy bandgap based in the temperature may be typically reduced to 0.4 to 0.5 nm/°C when converted to the wavelength. That is, a temperature increase of about 40°C may shift a bandgap wavelength to a longer wavelength of about 20 nm or reduce the energy bandgap.

As shown above, heat may be applied to the light source area 1000, thus reducing the light source energy bandgap 1130 to the same as the light source energy bandgap 1130 of a light source area 1010. Accordingly, the light source energy bandgap 1130 may be smaller than the modulator energy bandgap 1230 in the modulation area 1020.

As described above, the light source energy bandgap 1130 may thus be smaller than the modulator energy bandgap 1230 of the modulation area 1020. No reverse voltage may then be applied to the modulator in the modulator area 1020, and a size of the energy band gap 1230 of the modulator between a conduction band 1210 and a valence band 1220 may not be changed. In this case, the energy bandgap 1230 of the modulator area 1020 may be larger than a reduced energy bandgap 1030 of the light source area 1010. Therefore, light of the energy emitted from the light source may not be absorbed by the modulator and pass through the modulator as it is.

If the reverse voltage is applied to the modulator, the energy bandgap 1230 of a modulator area 1030 may be reduced by the quantum confined stark effect (QCSE) (for example, the energy bandgap 1230 may be equal to the reduced energy band gap 1130 of the light source area 1010) . In this case, the modulator area may effectively absorb light emitted from the light source, thus showing the basic feature (function) of the modulator.

In this embodiment, the energy bandgap of the light source area may be reduced using the heater to thus make the energy bandgap of the light source area smaller than the energy bandgap of the modulator area, thereby normally operating the modulator.

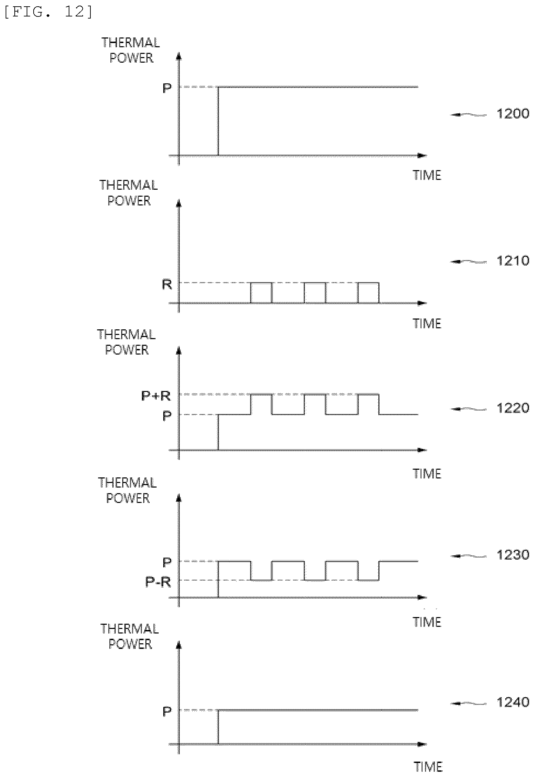

FIG. 12 is a diagram for explaining a method of controlling the heater when the optical device is operated in a burst mode according to an embodiment of the present invention.

Referring to FIGS. 7, 8, 9, 10, 11 and 12, in a time domain multiplexing (TDM) method, the light source may alternate between being completely off and on (on-off). Therefore, the light source of the optical device according to this embodiment may also be required to be turned on-off (or to be in the burst mode).

The heater 770 may generate thermal power P to acquire the energy bandgap 1130 of a desired light source (1200).

In the burst mode, thermal power R may be generated when the light source is on, and the thermal power may become zero when the light source is off (1210).

If the thermal power P generated by the heater 770 and the thermal power R generated when the light source is turned on in the burst mode are coupled to each other, the thermal power may not be constant and may be changed to power P plus R (P+R) and the power P (1220). In this case, not only the wavelength of the light source may be changed based on the thermal power, but also the energy bandgap may be changed over time.

Accordingly, the heater 770 of the present invention may change the thermal power of the heater 770 from P to P minus R (P-R) when the light source is turned on in the burst mode and the thermal power R is generated (1230). The controller (not shown) may control the heater 770 to be operated as above.

The thermal power of the heater 770 may be controlled to be changed from P to P minus R (P-R), thus allowing the thermal power P to remain constant even though the light source is turned on in the burst mode and the thermal power R is generated to be added to the thermal power of the heater 770.

Accordingly, the overall thermal power may remain constant even when the light source is turned on in the burst mode, thus allowing not only the wavelength of the light source to remain constant, but also the energy bandgap to remain constant even when the time is changed.

All or some of the respective embodiments may be selectively combined with each other so that the above-mentioned embodiments may be variously modified.

Further, it is to be noted that the embodiments are provided in order to describe the present invention rather than limiting the present invention. Furthermore, an expert in a technical field of the present invention will understand that various embodiments are possible within the spirit and scope of the present invention.

## Claims

1. An optical device comprising:
a first cladding layer formed on a substrate;
a multiple quantum well (MQW) active layer formed on the first cladding layer all over a light source area and a modulator area;
a second cladding layer formed on the MQW active layer; and
a heater controlling an energy bandgap of a light source by applying heat to the MQW active layer corresponding to the light source area.

2. The device of claim 1, wherein the heater increases a temperature of the MQW active layer corresponding to the light source area by applying heat thereto to thus reduce the light source energy bandgap, thereby making the light source energy bandgap smaller than a modulator energy bandgap in the modulator area.

3. The device of claim 1, wherein the second cladding layer in the light source area has a lower width that is smaller than an upper width.

4. The device of claim 3, further comprising:
a first electrode formed on the second cladding layer; and
an insulating film formed on the first electrode,
wherein the heater is formed on the insulating film.

5. The device of claim 1, wherein for the second cladding layer, a height of the cladding layer formed in the light source area or in the modulator area is higher than a height of the cladding layer formed between the light source area and the modulator area.

6. The device of claim 5, further comprising a second electrode formed on the second cladding layer in the modulator area.

7. The device of claim 1, wherein the heater maintains thermal power P to form a desired light source energy bandgap of the light source area, and
in a case where the optical device is driven in a burst mode, the thermal power P of the heater is changed to the thermal power P minus thermal power R (P-R) when the light source is turned on and the thermal power R is generated in the burst mode, thus allowing the thermal power P to remain constant even though the optical device is driven in the burst mode.
